# EUROPEAN PATENT APPLICATION

(11) **EP 1 728 890 A1**
(43) Date of publication of application: **06.12.2006**
(21) Application number: 05721537.8
(22) Date of filing: 18.03.2005
(51) Int. Cl.: C23C 14/14, C23C 14/34, B01J 37/02, H01M 4/88

(54) **FINE PARTICLE**

(30) Priority: 22.03.2004 JP 2004082515
(71) Applicant: Abe, Takayuki, Toyama-shi, Toyama 930-8555 (JP); Youtec Co., Ltd., Nagareyama-shi, Chiba 270-0156 (JP)
(72) Inventor: ABE, Takayuki, Hydrogen Isotope Research Center, Toyama-shi, Toyama 9308555 (JP); HONDA, Yuuji, YOUTEC CO., LTD., Nagareyama-shi, Chiba 2700156 (JP)
(74) Representative: Viering, Hans-Martin
(86) International application number: PCT/JP2005/005610
(87) International publication number: WO 2005/090630

(57) **Abstract**

A fine particle uniformly holding a substance having a catalytic influence on a surface. Sputtering is performed by agitating or rotating the fine particles 3 in a vacuum container 1, which has a polygon inner cross-section shape, by rotating the vacuum container 1, having a rotating axis almost vertical to the cross-section, and the surfaces of the fine particles 3 are coated with super-fine particles having a smaller particle diameter than that of the fine particle, or a thin film. The super-fine particle or the thin film is composed of at least a metal catalyst or an oxide catalyst or a composite catalyst.

## Description

### TECHNICAL FIELD

The present invention relates to a fine particle (for example, a fine particle having catalysis). Particularly, the present invention relates to a fine particle, a surface of which is coated with a thin film or the like in such a manner that, compared to conventional methods, impurities hardly come to be mixed in. Also, the present invention relates to a new preparation method of catalyst employing a barrel sputtering method, and a new catalyst.

### BACKGROUND ART

A catalyst is prepared by allowing a carrier such as Al₂O₃ to support a substance having catalysis such as an active metal. As preparation methods of the catalyst, a coprecipitation method, a kneading method, an impregnation method or the like are available (refer to, for example, a non-patent document "Industrial catalysts: Catalysts leading to technical innovations", Yoichi Nishimura, Takesige Takahashi; Baifukan, September 9, 2002, pp. 72). The coprecipitation method is a method for preparing the catalyst by allowing a solution of a substance such as an active metal and a carrier solution to precipitate together. The kneading method is a method for preparing the catalyst by mixing and kneading a precipitate of the active metal with a carrier powder. And the impregnate method is a method for preparing the catalyst by impregnating carrier pores with an active component solution.

### DISCLOSURE OF THE INVENTION

When impurities are mixed in the catalyst, the catalyst is apt to be catalyst-poisoned, resulting in a reduction of the activity of the catalyst. Therefore, it is preferred to prepare the catalyst in such a manner that impurities are prevented from coming to be mixed in as little as possible. Composition, disposal, shape, size and the like of a catalyst material supported on the carrier surface are factors extremely important for development of the catalysis. However, it has been difficult to control the above factors by employing the conventional methods of catalyst preparation. Therefore, it is requested to develop a technique for controlling the factors.

The present invention has been proposed in view of the above-mentioned problems. An object of the present invention is to provide a fine particle, a surface of which is coated with a thin film or the like using such a method that, compared to the conventional methods, impurities hardly come to be mixed in. Further, another object of the present invention is to provide a fine particle, a surface of which is coated with the catalyst by employing a method capable of controlling the composition, disposal, shape and size of the supported catalyst.

In order to solve the above problems, a fine particle according to the present invention is one coated with ultra-fine particles having a grain diameter smaller than that of the fine particle or a thin film on a surface of the fine particle, which is formed by carrying out a sputtering while stirring or rolling fine particles contained in a vacuum container having a polygonal internal shape in cross section by rotating the vacuum container about a rotating axis substantially perpendicular to the cross section, wherein the ultra-fine particle or the thin film is made of at least one of a metal catalyst, an oxide catalyst and a compound catalyst.

According to the invention, the sputtering is carried out while stirring or rolling the fine particles in the vacuum container; thereby the surface of the fine particles is coated with a metal catalyst or the like. Accordingly, the fine particle coated with the metal catalyst or the like by employing such a method that, compared to the conventional methods, impurities hardly come to be mixed in can be provided. Also, by controlling the conditions during the sputtering (an input power between electrodes, a rotating speed of the vacuum container, a gas pressure and the like), the shape, size (thickness), disposal, and composition of the coated catalyst can be controlled.

Another fine particle according to the invention is one coated with ultra-fine particles having a grain diameter smaller than that of the fine particle or a thin film on a surface of the fine particle, which is formed by carrying out a sputtering while stirring or rolling fine particles contained in a vacuum container having a polygonal internal shape in cross section by rotating the vacuum container about a rotating axis substantially perpendicular to the cross section while giving vibration to the fine particles, wherein the ultra-fine particle or the thin film is made of at least one of a metal catalyst, an oxide catalyst and a compound catalyst.

According to the present invention, the fine particle coated with the metal catalyst or the like using such a method that, compared to the conventional methods, impurities hardly come to be mixed in can be provided. In addition, the surface of the fine particle is coated with the metal catalyst or the like by carrying out a sputtering while stirring or rolling fine particles in the vacuum container as well as giving vibration to the fine particles. Therefore, the fine particles hardly aggregate or adhere to a wall surface of the barrel during the sputtering. Accordingly, compared to the conventional methods, the metal catalyst or the like can be formed more uniformly on the surface of the fine particles. Also, the fine particles can be caused to aggregate partially by controlling the magnitude, period of time and/or cycle of the vibration; and thus, the shape, size and disposal thereof can be freely controlled.

Another fine particle according to the present invention is one coated with ultra-fine particles having a grain diameter smaller than that of the fine particle or a thin film on a surface of the fine particle, which is formed by carrying out a sputtering while stirring or rolling fine particles contained in a vacuum container having a polygonal internal shape in cross section by rotating the vacuum container about a rotating axis substantially perpendicular to the cross section while directly or indirectly heating the vacuum container, wherein the ultra-fine particle or the thin film is made of at least one of a metal catalyst, an oxide catalyst and a compound catalyst.

According to the present invention, a fine particle coated with a metal catalyst or the like employing such a method that, compared to the conventional methods, impurities hardly come to be mixed in can be provided. The surface of the fine particle is coated with the metal catalyst or the like by carrying out the sputtering while stirring or rolling the fine particles in the vacuum container as well as heating the fine particles. Therefore, moisture within the vacuum container and moisture adhered onto the surface of the fine particles is easily evaporated; and thus the fine particles hardly aggregate during the sputtering. Accordingly, compared to the conventional methods, the metal catalyst or the like can be formed more uniformly on the surface of the fine particles. Also, the fine particles can be caused to aggregate partially by controlling the magnitude, period of time and/or cycle of the vibration; and thus, the shape, size and disposal thereof can be freely controlled. Moreover, the disposal, size (thickness), composition and shape of the metal catalyst or the like on the surface of the fine particles can be controlled by controlling the heating temperature and the heating time.

Another fine particle according to the present invention is one, in which ultra-fine particles having a grain diameter smaller than that of the fine particle or aggregations of the ultra-fine particles cohere continuously or discontinuously onto a surface of the fine particle. A substance having catalysis may be applied to the fine particle, the ultra-fine particles and the aggregation of the ultra-fine particles. However, the substance is not limited to the catalyst, but other substances having various characteristics may be applied. Also, the fine particle may be applied to not only the catalyst but also other various purposes.

The fine particle is one, in which ultra-fine particles having a grain diameter smaller than that of the fine particle or aggregations of the ultra-fine particles cohere continuously or discontinuously onto a surface of the fine particle, which is formed by carrying out a sputtering while stirring or rolling fine particles contained in a vacuum container having, for example, a polygonal internal shape in cross section by rotating the vacuum container about a rotating axis substantially perpendicular to the cross section.

Moreover, the fine particle is one, in which the ultra-fine particles having a grain diameter smaller than that of the fine particle or aggregations of the ultra-fine particles cohere continuously or discontinuously onto a surface of the fine particle, which is formed by carrying out a sputtering while stirring or rolling fine particles contained in a vacuum container having, for example, a polygonal internal shape in cross section by rotating the vacuum container about a rotating axis substantially perpendicular to the cross section while giving vibration to the fine particles.

Moreover, the fine particle is one, in which the ultra-fine particles having a grain diameter smaller than that of the fine particle or aggregations of the ultra-fine particles cohere continuously or discontinuously onto a surface of the fine particle, which is formed by carrying out a sputtering while stirring or rolling fine particles contained in a vacuum container having, for example, a polygonal internal shape in cross section by rotating the vacuum container about a rotating axis substantially perpendicular to the cross section while directly or indirectly heating the vacuum container.

The ultra-fine particles or aggregations of the ultra-fine particles may be made of, for example, at least one of the metal catalyst, the oxide catalyst and the compound catalyst. In this case, the metal catalyst is a metal selected from a group of Pt, Pd, Rh, Ru, Os, Ir, Re, Au, Ag, Fe, Ni, Ti, Al, Cu, Co, Mo, Mn, Nd, Zn, Ga, Ge, Cd, In, Sn, V, W, Cr, Zr, Mg, Si, P, S, Ca, Rb, Y, Sb, Pb, Bi, C and Li, the oxide catalyst is an oxide of one metal selected from the group, the compound catalyst is a mixture or an alloy of a plurality of metals selected from the group, a mixture of the respective oxides of a plurality of metals selected from the group, or a mixture of at least one metal selected from the group and an oxide of at least one metal selected from the group.

Moreover, the fine particle may be used as an electrode catalyst or an electrode material for a primary battery, a secondary battery, a solar battery or a fuel battery.

### BRIEF DESCRIPTION OF THE DRAWINGS

Fig. 1 is a diagram schematically showing a structure of a polygonal barrel sputtering device used in one embodiment of the present invention.
Fig. 2 is a schematic view showing a state that a surface of a fine particle 3 is coated with a substance having catalysis as a thin film 3a.
Fig. 3 (A) schematically shows a state that the surface of the fine particle 3 is coated discontinuously with a substance having catalysis as an ultra-fine particle 3b; and Fig. 3(B) schematically shows a state that the surface of the fine particle 3 is coated continuously therewith.
Fig. 4 schematically shows a state that the surface of the fine particle 3 is coated with a substance having catalysis as ultra-fine particles 3b and aggregations 3c of the ultra-fine particles.
Fig. 5(A) is a photograph showing fine particles (powder sample) before being sputtered and coated fine particles after being sputtered; and Fig. 5(B) is an optical microscopic photograph showing the fine particles (powder sample) before being sputtered and the coated fine particles after being sputtered.
Fig. 6(A) is a SEM photograph (500 magnifications) showing Al₂O₃ fine particles coated with Pt; Fig. 6 (B) is an element mapping of Al obtained by an analysis using a EDS; and Fig. 6(C) is an element mapping of Pt obtained by the analysis using the EDS.
Fig. 7(A) is a SEM photograph (5000 magnifications) showing Al₂O₃ fine particles coated with Pt; Fig. 7 (B) is an element mapping of Al obtained by the analysis using the EDS; and Fig. 7(C) is an element mapping of Pt obtained by the analysis using the EDS.

### BEST MODE FOR CARRYING OUT THE INVENTION

Hereinafter, preferred embodiments of the present invention will be described in detail with reference to the drawings.

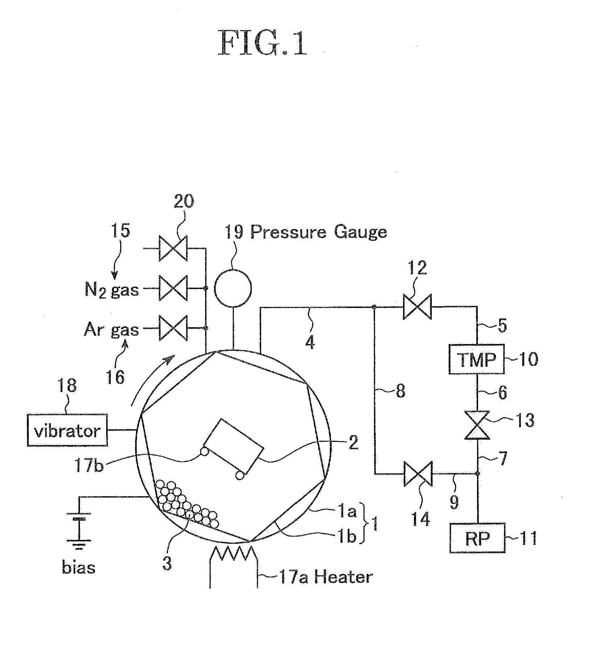

Fig. 1 is a diagram schematically showing a structure of a polygonal barrel sputtering device used in one embodiment according to the present invention. The polygonal barrel sputtering device is one for coating surfaces of fine particles (powder) with at least one of the metal catalyst, the oxide catalyst and the compound catalyst as ultra-fine particles having a grain diameter smaller than that of the fine particles (herein, the term "ultra-fine particle" means a fine particle having a grain diameter smaller than that of the fine particle) or thin film in a state free from impurities or with an extremely few impurities.

The polygonal barrel sputtering device has a vacuum container 1 for coating fine particles 3 with ultra-fine particles or thin films. The vacuum container 1 includes a cylindrical body 1a having a diameter of 200 mm and a barrel (hexagonal barrel) 1b having a hexagonal cross section arranged in the cylindrical body 1a. Here, the cross section is substantially parallel with a gravitational direction. Besides, in this embodiment, the barrel 1b having a hexagonal shape in its cross section is employed; however, the shape thereof may not be hexagonal but a polygonal barrel having a shape other than the hexagon (for example, quadrilateral-dodecagonal barrel) may be employed.

The vacuum container 1, which is provided with a rotating mechanism (not shown), is for, with this rotating mechanism, carrying out a coating treatment while rotating the hexagonal barrel 1b in a direction indicated with an arrow in Fig. 1 or in the inversed direction, or for shaking the hexagonal barrel 1b like a pendulum while stirring or rolling the fine particles 3 contained in the hexagonal barrel 1b. The rotating mechanism rotates the hexagonal barrel about a rotating axis parallel with a substantially horizontal direction (perpendicular to a gravitational direction). In the central axis of the cylinder within the vacuum container 1, a sputtering target 2, which is made of a substance having catalysis or a substance capable of producing such a substance with the reactive sputtering, is disposed. The target 2 is arranged so that the angle thereof can be changed freely. Owing to this, the target 2 can be faced to a direction where the fine particles 3 are located when carrying out the coating treatment while rotating the hexagonal barrel 1b or reversing the rotation direction thereof, or shaking the hexagonal barrel 1b like a pendulum; thereby a sputtering efficiency can be increased.

As the substance constituting the target 2, one metal selected from a metal group of Pt, Pd, Rh, Ru, Os, Ir, Re, Au, Ag, Fe, Ni, Ti, Al, Cu, Co, Mo, Mn, Nd, Zn, Ga, Ge, Cd, In, Sn, V, W, Cr, Zr, Mg, Si, P, S, Ca, Rb, Y, Sb, Pb, Bi, C and Li; one of oxides of the metals included in the above metal group; a mixture or an alloy of a plurality of metals selected from the above metal group; or a mixture of at least one metal selected from the above metal group and an oxide of at least one metal included in the above metal group. As for oxides of the metals, for example, TiO₂, NiO, Co₂O₃, Ee₂O₃, Al₂O₃, Cr₂O₃, V₂O₅, Cu₂O, ZnO₂, CdO, Tn₂O₃ and the like are available. Also, only one kind of the target 2 may be used, but plural kinds of target 2 may be used for the target 2 disposed in the vacuum container 1. For example, a plurality of targets made of a plurality of metals respectively, which are selected from the above metal group, may be disposed, being aligned with each other as the target 2. Or, a target made of one metal, which is selected from the above metal group, and a target made of an oxide of a metal, which is included in the above metal group, may be disposed, being aligned with each other.

The substance for coating the fine particles 3 is the same substance that constitutes, for example, the target 2. When a plurality of kinds of the targets 2 is used, a mixture or an alloy of the substances used for the targets is used. Also when the target 2 is made of a mixture or an alloy of one or a plurality of metals selected from the above metal group and yet when the reactive sputtering is carried out, the substance for coating the fine particles 3 is a substance generated from a substance constituting the target 2 (for example, oxide), or a mixture of the generated substance and a substance constituting the target 2.

One end of a pipe 4 is connected to the vacuum container 1, and the other end of the pipe 4 is connected to one side of a first valve 12. The other side of the first valve 12 is connected to one end of a pipe 5, and the other end of the pipe 5 is connected to an inlet side of a turbo molecular pump (TMP) 10. An outlet side of the turbo molecular pump 10 is connected to one end of a pipe 6, and the other end of the pipe 6 is connected to one side of a second valve 13. The other side of the second valve 13 is connected to one end of a pipe 7, and the other end of the pipe 7 is connected to a pump (RP) 11. And the pipe 4 is connected to one end of a pipe 8, and the other end of the pipe 8 is connected to one side of a third valve 14. The other side of the third valve 14 is connected to one end of a pipe 9, and the other end of the pipe 9 is connected to the pipe 7.

The device according to the present invention is provided with a heater 17a for directly heating the fine particles 3 in the vacuum container 1 and a heater 17b for indirectly heating the fine particles 3. The device is further provided with a vibrator 18 for giving vibration to the fine particles 3 in the vacuum container 1. The device is also provided with a pressure gauge 19 for measuring an internal pressure in the vacuum container 1. Further, the device is provided with a nitrogen gas supplying unit 15 for introducing nitrogen gas into the vacuum container 1 and an argon gas supplying unit 16 for introducing argon gas into the vacuum container 1. Moreover, the device is provided with a gas supplying unit 20 for introducing oxygen or the like for allowing the reactive sputtering to be performed. Moreover, the device is provided with a high frequency wave applying unit (not shown) for applying a high frequency wave between the target 2 and the hexagonal barrel 1b. And the device is also arranged so that a direct current is applied between the target 2 and the hexagonal barrel 1b.

Now, a polygonal barrel sputtering method for coating the fine particle 3 with ultra-fine particles or a thin film using the polygonal barrel sputtering device will be explained.

Initially, the fine particles 3 of, for example, 6 gram are introduced into the hexagonal barrel 1b. As the fine particles 3, for example, α-Al₂O₃ powder (manufactured by Nilaco. Co. Ltd., purity: 99.9%) having a size of 120 mesh is used but is not limited thereto. Another material such as metal powder, macromolecule powder, oxide powder, nitride powder, carbide powder, carbon powder or zeolite powder may be used. The polygonal barrel sputtering method makes it possible to coat various types of material powder with ultra-fine particles or a thin film of a substance having catalysis.

Then, the pressure within the hexagonal barrel 1b is reduced to, for example, 5×10⁻⁴ Pa to create a high vacuum state using the turbo molecular pump 10 while heating the hexagonal barrel up to, for example, 200°C with the heaters 17. After that, an inert gas such as argon or nitrogen is introduced into the hexagonal barrel 1b through the argon gas supplying unit 16 or the nitrogen gas supplying unit 15. Here, the pressure within the hexagonal barrel is, for example, approximately 2 Pa. Depending on the case, a mixed gas with oxygen or hydrogen may be introduced into the hexagonal barrel 1b. The hexagonal barrel 1b is rotated through the rotating mechanism at a speed of 20 rpm for 30 minutes with a power of 100 W; thereby the fine particles 3 in the hexagonal barrel 1b are rolled and stirred. At this time, the target is oriented to a direction where the fine particles 3 are located. After that, when high frequency waves are applied between the target 2 and the hexagonal barrel 1b through the high frequency wave applying unit, the substance having catalysis is sputtered onto the surface of the fine particles 3. Thus, the substance having catalysis is supported on the surface of the fine particles 3 as the ultra-fine particles or a thin film.

According to the above-described embodiment, the powder itself can be rolled and stirred by rotating the hexagonal barrel itself; and further, the barrel assumes a hexagonal shape, thereby allowing the powder to fall at specific intervals due to the gravitation. Owing to this, the stirring efficiency can be largely improved and the powder can be prevented from being aggregated due to the existence of moisture and/or electrostatic force, which often causes a problem during handling the powder. That is, owing to the rotation, the stirring of the powder and crushing of aggregated powder are carried out simultaneously and effectively. Also, the fine particles hardly adhere onto a wall surface of the hexagonal barrel 1b. Thus, the fine particles having an extremely small grain diameter can be coated with either ultra-fine particles having a grain diameter further smaller than that of the fine particle substance having catalysis or thin films. In particular, the fine particles having a grain diameter of 10 nm or more and 10 mm or less can be coated with either ultra-fine particles of a substance having catalysis or thin films. Here, compared to catalysts prepared in the conventional method, the ultra-fine particles or thin films include extremely fewer impurities, or are free from the impurities. In some cases, the ultra-fine particles continuously adhere onto the surface of the fine particle, and in other cases, the ultra-fine particles adhere discontinuously onto the surface of the fine particle as a single particle or an aggregation thereof.

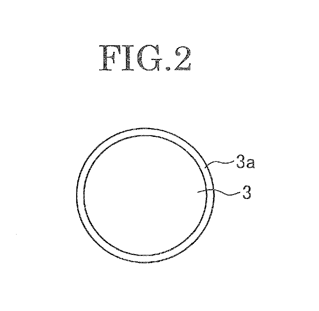

Fig. 2 is a schematic view showing a state that a surface of the fine particle 3 is coated with a substance having catalysis as the thin film 3a. For example, when a substance having the catalysis is sputtered to deposit on the surface of the fine particle 3 at a slow depositing speed under a high temperature, the thin film 3a is formed on the surface of the fine particle 3.

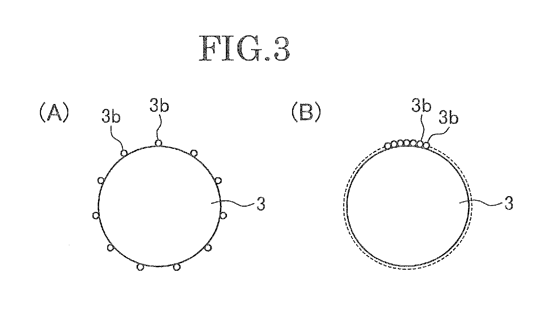

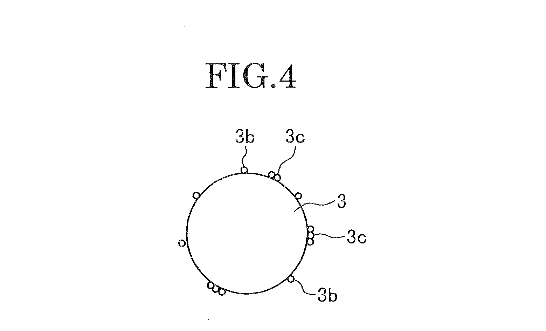

Fig. 3(A) schematically shows a state that a surface of the fine particle 3 is coated discontinuously with substances having catalysis as the ultra-fine particles 3b; and Fig. 3(B) schematically shows a state that a surface of the fine particle 3 is coated continuously therewith. Fig. 4 schematically shows a state that a surface of the fine particle 3 is coated with substances having catalysis as the ultra-fine particles 3b and aggregations 3c of the ultra-fine particles. For example, when a substance having catalysis is sputtered to deposit on the surface of the fine particle 3 at a fast depositing speed, in a shorter sputtering time, or in an intermittent manner, the ultra-fine particles 3b and an aggregation 3c of the ultra-fine particles are formed on the surface of the fine particle 3. The shape of the substance deposited on the surface of the fine particle 3 varies depending the gas pressure.

As described above, by changing sputtering conditions, the state that the substance having catalysis coats the surface of the fine particle 3 is changed. In the case of a fine particle of an alloy, the composition can be changed by changing the sputtering conditions.

Further, in this embodiment, the heater 17a is mounted onto the outside of the vacuum container 1, and the heater 17b is mounted onto a target cover of the target 2 respectively. The hexagonal barrel 1b can be heated up to 700°C by the heaters 17a and 17b. Owing to this arrangement, when the hexagonal barrel 1b is heated by the heaters 17a and 17b to make a vacuum state inside the vacuum container 1, moisture absorbed in the hexagonal barrel 1b and in fine particles 3 can be evaporated and exhausted. Therefore, the moisture, which causes a problem during handling the powder, can be removed from the inside of the hexagonal barrel 1b; and thus, the powder can be effectively prevented from being aggregated. Further, the shape, size, disposal and composition of the substance coating the fine particle 3 can be controlled by controlling the heating temperature and heating time during the sputtering.

Moreover, in this embodiment, the vibrator 18 is provided outside the vacuum container 1. Vibration can be given to the fine particles 3 in the hexagonal barrel with the vibrator 18. Owing to this, aggregation of the powder, which causes a problem while handling the powder, can be effectively prevented. Since the fine particles 3 adhered on the wall surface of the hexagonal barrel can be removed therefrom, further uniform coating can be achieved.

The fine particles manufactured as described above are applicable to various catalysts such as industrial catalyst, for example, automobile exhaust gas catalyst (ternary catalyst), hydrocracking catalyst, deodorizing catalyst, selective hydro-treating catalyst, dehydrogenation catalyst, reforming catalyst, hydrodesulfurization catalyst, denigration catalyst (de-Nox catalyst), various polymerization catalyst, waste-water treatment catalyst. Further, it is needless to say that such fine particles are applicable to electrode catalyst or an electrode material for a primary battery, a secondary battery, a solar battery or a fuel battery. In the catalyst, since the surface of the fine particle is coated with a substance having catalysis, the surface area as the catalyst is increased. Also, as for the amount of the substance having catalysis may be smaller than the conventional amount. Therefore, the cost of the catalyst for obtaining the same performance can be reduced. Moreover, different from conventional methods, the substance having catalysis does not have to be dissolved into a solution. Therefore, not only that fine particles can be coated with various kinds of substances but also, the shape, size, disposal, composition thereof can be variously controlled.

Next, results of analyses of a specimen (coated fine particle), in which the surface of fine particles of Al₂O₃ is coated with Pt as a substance having catalysis using the above-described polygonal barrel sputtering method, will be described.

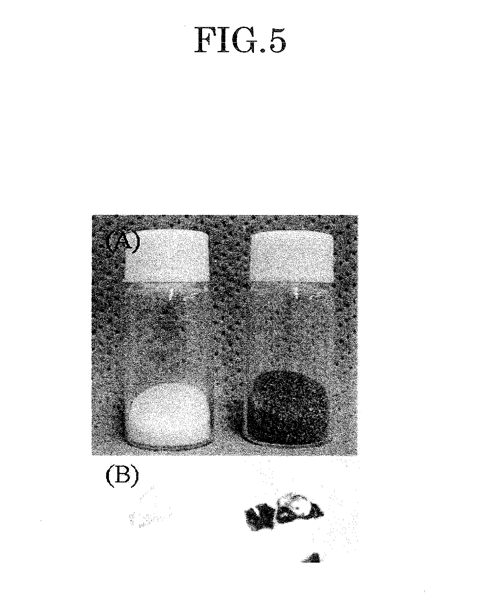

Fig. 5(A) is a photograph showing fine particles (powder sample) before being sputtered, and coated fine particles after being sputtered. As shown in Fig. 5(A), the Al₂O₃ powder before sputtering shows a white and translucent color. On the other hand the coated fine particles after sputtering obviously have a metallic luster. Since no while particles can be observed on the coated fine particles after sputtering, it is considered that every particle be uniformly coated with Pt.

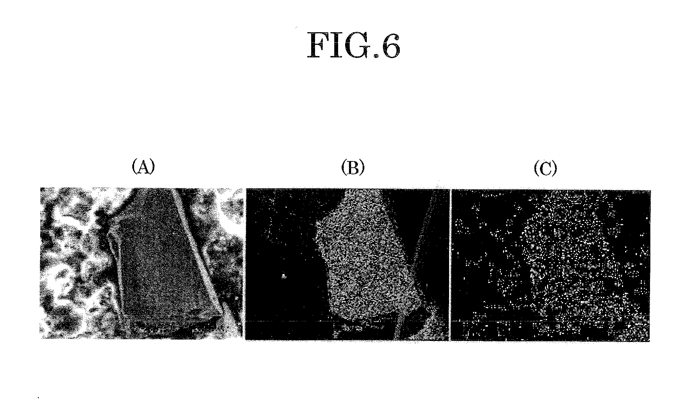

In order to examine the feature of the coating Pt, the surface of the powder was examined with a SEM (scanning electron microscope: 500 magnifications). The observation results are shown in Fig. 6.

Fig. 6(A) is a SEM photograph (500 magnifications) showing Al₂O₃ fine particles coated with Pt. In Fig. 6(A), the particles have a quadratic prism-like shape formed with plain surfaces and sharp edges, but no projection or recession, which is occasionally formed by sputtering, is observed.

An elementary analysis was made for the Al₂O₃ fine particles coated with Pt using the EDS. The results of the analysis are shown in Figs. 6(B) and (C). Fig. 6 (B) is an element mapping of Al obtained by the analysis using the EDS; and Fig. 6(C) is an element mapping of Pt obtained by the analysis using the EDS.

Fig. 6(B) shows that Al elements are uniformly distributed over the particle. It is observed that concentration of the Al element is low on the side surface of the particle due to the inclination of the surface. Contrarily, as shown in Fig. 6 (C), although the concentration of the Pt elements is not as high as that of the Al elements, Pt is uniformly detected all over the particle.

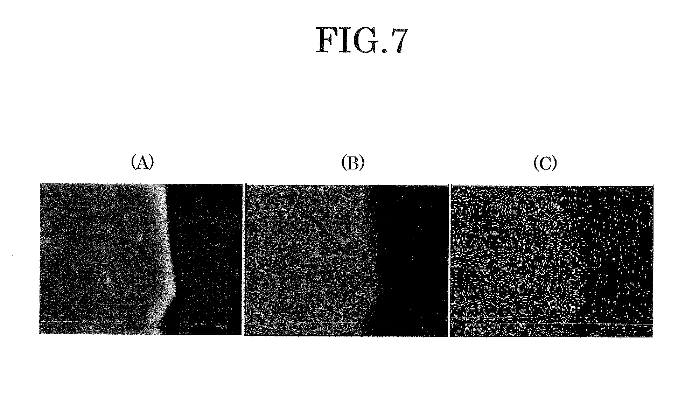

In order to examine the feature of Pt coating the surface of the particles further in detail, the surface of the specimen was observed with larger magnifications (5000 magnifications). The observation result is shown in Fig. 7.

Fig. 7(A) is a SEM photograph (5000 magnifications) showing Al₂O₃ fine particles coated with Pt. In the SEM photograph shown in Fig. 7(A), the left side with higher contrast is the surface of the particles. The photograph shows that the surface of the particles is extremely flat.

The elementary analysis was made using the EDS for the Al₂O₃ fine particle coated with Pt. The results of the analysis are shown in Figs. 7(B) and (C). Fig. 7(B) is an element mapping of Al obtained by the analysis using the EDS; and Fig. 7(C) is an element mapping of Pt obtained by the analysis using the EDS. Fig. 7(B) shows that Al elements are uniformly distributed similarly to the surface shape of the particle. Fig. 7(C) shows that, although concentration of the Pt elements is lower than that of the Al elements, the Pt elements are uniformly distributed on the surface of the particles. And Fig. 7(C) shows that the particle is coated with Pt elements as far as the tip of edge portion thereof.

It is found from the above observation results that, the surface of the fine particle is coated with Pt as a film in the observed fine particles 3. This observation result is the identical to those of several other fine particles 3, which are prepared simultaneously. Therefore, it is presumed that every fine particle prepared simultaneously is coated with a uniform Pt film.

The Pt film coating the fine particle 3 was dissolved into aqua regalis, and an ICP analysis was made for the substances constituting the Pt film. As a result, no substance other than Pt was detected. As described above, this embodiment employs the sputtering method. Therefore, the substance, which has catalysis and coats the surface of the fine particle, includes no impurities or extremely small amount, if any. Accordingly, compared to the conventional catalysts, the higher active catalyst can be obtained.

The present invention is not limited to the above-described embodiment, but it is possible to implement the present invention while variously modifying within a scope of the spirit of the present invention.

For example, in the above-described embodiment, the vibrator 18 imparts vibration to the fine particles 3 in the hexagonal barrel. However, in a state that a rod-like member is stored in the hexagonal barrel in place of or in addition to the vibrator 18, when the hexagonal barrel is rotated, vibration can be given to the fine particles 3. In this manner also, the aggregation, which causes a problem during handling the powder, can be effectively prevented.

## Claims

1. A fine particle coated with ultra-fine particles having a grain diameter smaller than that of the fine particle or a thin film on a surface of the fine particle, which is formed by carrying out a sputtering while stirring or rolling fine particles contained in a vacuum container having a polygonal internal shape in cross section by rotating the vacuum container about a rotating axis substantially perpendicular to said cross section, wherein
Said ultra-fine particle or said thin film is made of at least one of a metal catalyst, an oxide catalyst and a compound catalyst.

2. A fine particle coated with ultra-fine particles having a grain diameter smaller than that of the fine particle or a thin film on a surface of the fine particle, which is formed by carrying out a sputtering while stirring or rolling fine particles contained in a vacuum container having a polygonal internal shape in cross section by rotating the vacuum container about a rotating axis substantially perpendicular to said cross section while giving vibrations to said fine particles, wherein
Said ultra-fine particle or said thin film is made of at least one of a metal catalyst, an oxide catalyst and a compound catalyst.

3. A fine particle coated with ultra-fine particles having a grain diameter smaller than that of the fine particle or a thin film on a surface of the fine particle, which is formed by carrying out a sputtering while stirring or rolling fine particles contained in a vacuum container having a polygonal internal shape in cross section by rotating the vacuum container about a rotating axis substantially perpendicular to said cross section while directly or indirectly heating said vacuum container, wherein
Said ultra-fine particle or said thin film is made of at least one of a metal catalyst, an oxide catalyst and a compound catalyst.

4. A fine particle, in which ultra-fine particles having a grain diameter smaller than that of said fine particle or aggregations of said ultra-fine particles cohere continuously or discontinuously on a surface of said fine particle.

5. The fine particle according to claim 4, in which ultra-fine particles having a grain diameter smaller than that of said fine particle or aggregations of said ultra-fine particles cohere continuously or discontinuously onto a surface of said fine particle, which is formed by carrying out a sputtering while stirring or rolling fine particles contained in a vacuum container having a polygonal internal shape in cross section by rotating the vacuum container about a rotating axis substantially perpendicular to said cross section.

6. The fine particle according to claim 4, in which ultra-fine particles having a grain diameter smaller than that of said fine particle or aggregations of said ultra-fine particles cohere continuously or discontinuously on a surface of said fine particle, which is formed by carrying out a sputtering while stirring or rolling fine particles contained in a vacuum container having a polygonal internal shape in cross section by rotating the vacuum container about a rotating axis substantially perpendicular to said cross section while giving vibrations to said fine particles.

7. The fine particle according to claim 4, in which ultra-fine particles having a grain diameter smaller than that of said fine particle or aggregations of said ultra-fine particles cohere continuously or discontinuously onto a surface of said fine particle, which is formed by carrying out a sputtering while stirring or rolling fine particles contained in a vacuum container having a polygonal internal shape in cross section by rotating the vacuum container about a rotating axis substantially perpendicular to said cross section while directly or indirectly heating said vacuum container.

8. The fine particle according to any one of claims 4 to 7, wherein said ultra-fine particles or aggregations of said ultra-fine particles are made of at least one of a metal catalyst, an oxide catalyst and a compound catalyst.

9. The fine particle according to any one of the claims 1 to 3 and 8, wherein said metal catalyst is a metal selected from a group of Pt, Pd, Rh, Ru, Os, Ir, Re, Au, Ag, Fe, Ni, Ti, Al, Cu, Co, Mo, Mn, Nd, Zn, Ga, Ge, Cd, In, Sn, V, W, Cr, Zr, Mg, Si, P, S, Ca, Rb, Y, Sb, Pb, Bi, C and Li,
Said oxide catalyst is an oxide of one metal selected from said group,
said compound catalyst is a mixture or an alloy of a plurality of metals selected from said group, a mixture of the respective oxides of a plurality of metals selected from said group, or a mixture of at least one metal selected said group and an oxide of at least one metal selected from said group.

10. The fine particle according to any one of claims 1 to 9, wherein said fine particle is used as an electrode catalyst or an electrode material for a primary battery, a secondary battery, a solar battery or a fuel battery.
